# EUROPEAN PATENT APPLICATION

(11) **EP 2 476 538 A2**
(43) Date of publication of application: **18.07.2012**
(21) Application number: 12150939.2
(22) Date of filing: 12.01.2012
(51) Int. Cl.: B29C 59/02

(54) **Method of imprinting texture on rigid substrate using flexible stamp**

(30) Priority: 13.01.2011 IN 7300002011
(71) Applicant: Moser Baer India Ltd., New Dehli 110020 (IN)
(72) Inventor: Titulaer, Bram, 110020 New Dehli (IN)
(74) Representative: Beck & Rössig European Patent Attorneys

(57) **Abstract**

A method of imprinting a texture on a rigid substrate (202), having area greater than 50 square centimeters, preferably greater than 200 square centimeters, is provided. The texture imprinted on the rigid substrate (202) facilitates light management through the rigid substrate (202). The method includes wet coating a layer of a curable material (204) on the rigid substrate (202). Thereafter, the method includes pressurizing a flexible stamp (206) over the layer of curable material (204) to imprint the texture. The flexible stamp (206) includes a bottom zone (304) having a texture profile corresponding to the texture. The bottom zone (304) has Young's Modulus between 0.5 MPa and 3000 MPa and enables tolerance for microscopic defects during imprinting of the texture. The flexible stamp (206) also includes a top zone (302) having Young's Modulus between 0.1 GPa and 10 GPa. The top zone (302) enables tolerance for macroscopic defects. Further, the method includes curing the layer of curable material (204). Finally, the method includes removing the flexible stamp (206).

## Description

### FIELD OF INVENTION

The invention disclosed herein relates, in general, to imprinting texture on a rigid substrate using flexible stamp. More specifically, the present invention relates to imprinting light management (light extraction or light trapping) textures on rigid substrates used in manufacturing of photovoltaic devices and/or Organic Light Emitting Diodes (OLEDs).

### BACKGROUND

Photovoltaic devices such as thin film solar cells have the ability to capture incident solar light. Efficiency of these devices is determined by their ability to absorb maximum amount of light. To assist trapping of the incident light and to enhance absorption of light, light trapping textures are provided in thin film solar cells. Typical texture size for thin film solar cells is in the range of 50-600 nanometers. Similarly, efficiency of Organic Light Emitting Diodes (OLEDs) depends mainly on their ability to extract maximum light generated in layer stack. Using light extraction light extraction textures contribute significantly in increasing the efficiency of OLEDs as well.

As such textures need to manage light at nanometer levels, extremely high level of accuracy is required. These nano scale textures are generally manufactured by sophisticated and complex techniques such as lithography. Further, conventionally this technique cannot be used for large area texturing (greater than a 6-inch wafer or 50 square centimeters) due to the complexity (accuracy needed and high costs involved) of equipment needed for large-area photolithographic exposure, making it unsuitable for large sizes and robust mass manufacturing of large devices.

Another commonly used method to form such textures is through use of rigid stamp. In this method, a rigid stamp with a textured surface is pressed on a curable material deposited over the substrate. However, this process may lead to microscopic and macroscopic defects due to the unevenness of substrate surface and presence of impurities or any foreign unwanted particle.

In light of the above discussion, there is a need for a method for imprinting highly accurate defect-free light management textures on large area rigid substrates. Further, the method should also be suitable for low-cost, mass manufacturing.

### SUMMARY

An object of the present invention is to provide a method of imprinting highly accurate texture on a rigid substrate.

Another object of the present invention is to provide a method of imprinting defect free texture on a rigid substrate.

Yet another object of the present invention is to provide a method of imprinting a texture on a rigid substrate that is suitable for mass manufacturing.

Yet another object of the present invention is to provide a method of imprinting a texture on a rigid substrate that is suitable of large area texturing.

The present invention provides a method of imprinting a texture on a rigid substrate as defined in the claims.

Some embodiments of the present invention provide a method for manufacturing a photovoltaic device.

Some embodiments of the present invention provide a method for manufacturing an Organic Light Emitting Diode (OLED).

In some embodiments, a method of imprinting a texture on a large area rigid substrate, having area greater than 50 square centimeters, and preferably, greater than 200 square centimeters, is provided. The texture imprinted on the rigid substrate facilitates light management, i.e., either light trapping or light extraction. The method includes wet coating a layer of a curable material on the rigid substrate. Thereafter, the method includes pressurizing a flexible stamp over the layer of curable material to imprint the texture. The flexible stamp can be pressurized in various ways. The flexible stamp has two zones, a bottom zone and a top zone. The bottom zone has a texture profile corresponding to the texture and has Young's Modulus between 0.5 Mega Pascal (MPa) and 3000 MPa. This enables tolerance for microscopic defects during imprinting the texture. The top zone has Young's Modulus between 0.1 Giga Pascal (GPa) and 10 GPa, enabling tolerance for macroscopic defects and unevenness of the substrate while imprinting the texture. Further, the method includes curing the layer of curable material. Finally, the method includes removing the flexible stamp.

### BRIEF DESCRIPTION OF FIGURES

The features of the present invention, which are believed to be novel, are set forth with particularity in the appended claims. The invention may best be understood by reference to the following description, taken in conjunction with the accompanying drawings. These drawings and the associated description are provided to illustrate some embodiments of the invention, and not to limit the scope of the invention.
FIG. 1a is a diagrammatic illustration of various components of an exemplary photovoltaic device according to an embodiment of the present invention;
FIG. 1b is a diagrammatic illustration of various components of an exemplary OLED according to an embodiment of the present invention;
FIGs. 2a and 2b are diagrammatic illustrations depicting defects that are created when a rigid stamp is used to imprint texture on the rigid substrate;
FIGs. 2c and 2d are diagrammatic illustrations depicting of use of flexible stamp to imprint texture on the rigid substrate in accordance with the current invention;
FIG. 3 is a diagrammatic illustration of a flexible stamp, in accordance with an embodiment of the present invention;
FIG. 4 is a flow chart describing a method of imprinting texture on a rigid substrate, in accordance with an embodiment of the present invention;
FIG. 5 is a diagrammatic illustration depicting exemplary method of imprinting texture on the rigid substrate, in accordance with some embodiments of the present invention;
FIG. 6 is a diagrammatic illustration depicting use of a flexible stamp to imprint a texture on the rigid substrate, in accordance with an embodiment of the present invention;
FIG. 7 is another diagrammatic illustration depicting use of a flexible stamp to imprint a texture on the rigid substrate, in accordance with another embodiment of the present invention;
FIG. 8 is a diagrammatic illustration depicting exemplary method of manufacturing a flexible stamp, in accordance with an embodiment of the present invention; and
FIGs. 9a and 9b depict exemplary textures that are imprinted using a flexible stamp, in accordance with some embodiments of the present invention.

Those with ordinary skill in the art will appreciate that the elements in the figures are illustrated for simplicity and clarity and are not necessarily drawn to scale. For example, the dimensions of some of the elements in the figures may be exaggerated, relative to other elements, in order to improve the understanding of the present invention.

There may be additional structures described in the foregoing application that are not depicted on one of the described drawings. In the event such a structure is described, but not depicted in a drawing, the absence of such a drawing should not be considered as an omission of such design from the specification.

### DESCRIPTION OF THE EXEMPLARY EMBODIMENTS

The instant exemplary embodiments provide a method of imprinting a texture on a rigid substrate.

Before describing the present invention in detail, it should be observed that the present invention utilizes a combination of method steps and apparatus components related to a method of imprinting a texture on a rigid substrate. Accordingly the apparatus components and the method steps have been represented where appropriate by conventional symbols in the drawings, showing only specific details that are pertinent for an understanding of the present invention so as not to obscure the disclosure with details that will be readily apparent to those with ordinary skill in the art having the benefit of the description herein.

While the specification concludes with the claims defining the features of the invention that are regarded as novel, it is believed that the invention will be better understood from a consideration of the following description in conjunction with the drawings, in which like reference numerals are carried forward.

As required, detailed embodiments of the present invention are disclosed herein; however, it is to be understood that the disclosed embodiments are merely exemplary of the invention, which can be embodied in various forms. Therefore, specific structural and functional details disclosed herein are not to be interpreted as limiting, but merely as a basis for the claims and as a representative basis for teaching one skilled in the art to variously employ the present invention in virtually any appropriately detailed structure. Further, the terms and phrases used herein are not intended to be limiting but rather to provide an understandable description of the invention.

The terms "a" or "an", as used herein, are defined as one or more than one. The term "another", as used herein, is defined as at least a second or more. The terms "including" and/or "having" as used herein, are defined as comprising (i.e. open transition). The term "coupled" or "operatively coupled" as used herein, is defined as connected, although not necessarily directly, and not necessarily mechanically.

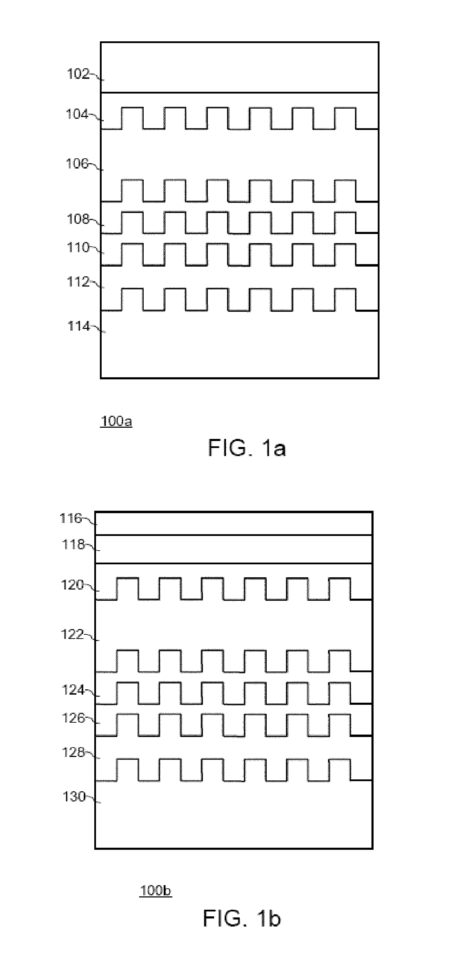

Referring now to the drawings, there is shown in FIG. 1a, a diagrammatic illustration of various components of an exemplary photovoltaic device 100a according to an embodiment of the present invention. In this illustration the photovoltaic device 100a is shown to be a thin film solar cell, however, the photovoltaic device 100a can be an organic solar cell, an amorphous silicon solar cell, a microcrystalline silicon solar cell, a micromorph silicon tandem solar cell, a Copper Indium Gallium Selenide (CIGS) solar cell, a Cadmium Telluride (CdTe) solar cell, and the like. The photovoltaic device 100a is shown to include a stack of a rigid substrate 102, a layer 104 of curable material, a layer 106 of transparent conductive oxide (TCO), multiple semiconductor layers 108, 110, 112 and a cover substrate 114.

The substrate 102 provides strength to the photovoltaic device 100a and is used as a starting point for deposition of other layers over it. Examples of the rigid substrate 102 include, but are not limited to, glass and transparent plastics. In an example, the substrate can be made of soda-lime glass having a thickness of 1.1mm. In another example, the rigid substrate 102 could be an optically transparent glass, plastic or polymer. The rigid substrate 102 provides strength and acts as a base for deposition of various layers for manufacturing of the photovoltaic device 100a.

Moving on to the layer 104 of the curable material. The layer 104 of the curable material is deposited over the substrate 102. The curable material should be able to retain any nano-texture embossed on it when it is cured by using thermal, light, ultra violet (UV), or any curing mechanism. The curable material converts to a hard plastic-like polymer or a glass-like material when exposed to thermal radiations or UV. The curable material can include, but is not limited to, an ultra-violet curable material, a photo-polymer lacquer, an acrylate, and silica or silica-titania based sol-gel material.

In accordance with the present invention, a texture is imprinted on the layer 104 of the curable material. The examples of the texture include, but are not limited to, V-shaped or U-shaped features, a 1D or 2D periodic grating (rectangular or sinusoidal), a blazed grating, and random pyramids. The width and height of the texture-features is in the range from 100 nm up to 10 µm. This texture is such that it that enables and enhances light trapping capability of semiconductor layers of the photovoltaic device 100a. This texture may also help in scattering and/or diffraction of the light and thus, enhances the light path through the photovoltaic device 100a and hence, enhances the chance of absorption of light by the semiconductor layers of the photovoltaic device 100a. Further these textures can be random or periodic in nature.

Moving on to the layer 106 of TCO. The layer 106 of TCO is deposited over the layer of curable material 104. TCOs are doped metal oxides used in photovoltaic devices. Examples of TCOs include, but are not limited to, Aluminum-doped Zinc Oxide (AZO), Boron doped Zinc Oxide (BZO), Gallium doped Zinc Oxide (GZO), Fluorine doped Tin Oxide (FTO) and Indium doped Tin Oxide (ITO). Typically, TCOs have more than 80% transmittance of incident light and have conductivities higher than 10³ S/cm for efficient carrier transport. The transmittance of TCOs, just as in any transparent material, is limited by light scattering at defects and grain boundaries.

Next set of layers in the stack of photovoltaic device 100a are the semiconductor layers 108, 110 and 112. Generally, the semiconductor layers are deposited using chemical vapour deposition, sputtering, and hot wire techniques on the layer 106 of TCO. For example, the semiconductor layers can include a layer of p-doped semiconductor 108, a layer of intrinsic semiconductor 110, and a layer of n-doped semiconductor 112. However, it will be readily apparent to those skilled in the art that the photovoltaic device 100a include or exclude one or more semiconductor layers without deviating from the scope of the invention.

Following the semiconductor layers, a cover substrate 114 is deposited. The cover substrate 114 incorporates the back contact of the photovoltaic device 100a. In some cases, commercially available photovoltaic device 100a may have additional layers to enhance their efficiency or to improve the reliability.

All the above mentioned layers are encapsulated using an encapsulation to obtain the photovoltaic device 100a. It should be noted that above description of the photovoltaic device 100a is for illustration purpose only. There can be various configurations of photovoltaic device 100a possible. A person ordinarily skilled in the art would appreciate that this invention can be implemented with various possible variations of photovoltaic device 100a.

Referring now to FIG. 1b, there is shown a stack of layers in an exemplary organic light emitting device (OLED) 100b. The OLED 100b is shown to include an external light extraction layer 116, a transparent substrate 118, an internal light extraction layer 120, a first electrode 122, one or more semiconductor layers 124 and 126, a second electrode 128 and a cover substrate 130, which encapsulates the internal light extraction layer 120, the first electrode 122, the one or more semiconductor layers 124 and 126 and the second electrode 128 between itself and the transparent substrate 118. Each layer of the OLED 100b, apart from the external light extraction layer 116 and the internal light extraction layer 120, can be coated or otherwise applied on the adjacent layer to implement the present invention.

The transparent substrate 118 provides strength to the OLED 100b, and also acts as the emissive surface of the OLED 100b when in use. The examples of the transparent substrate 118 include, but are not limited to, glass, flexible glass, polyethylene terephthalate (PET), polyethylene naphthalate (PEN), and other transparent or translucent material.

The internal light extraction layer 120 is a layer of the curable material. The curable material has a characteristic to retain any nano-texture embossed in it when it is cured by using mediums such as thermal, light, ultra-violet radiations, and the like. The curable material can include, but is not limited to, an ultra-violet curable material, a photo-polymer lacquer, an acrylate, and silica or silica-titania based sol-gel materials.

In accordance with the present invention, a texture is imprinted in the internal light extraction layer 120. This texture is such that it that enables and enhances light extraction capability of the OLED 100b. In some embodiments, the external light extraction layer 116 can also have textures similar to the internal light extraction layer 120. Texture on the external light extraction layer 116 can also be formed in a manner similar to the internal light extraction layer 120. These textures can be random or periodic in nature.

The first electrode 122 and the second electrode 128 are used to apply a voltage across the one or more semiconductor layers 124 and 126. The first electrode 122 and the second electrode 128, can be implemented with, for example, transparent conductive oxide (TCO), such as indium tin oxide (ITO) or other metals with appropriate work function to make injection of charge carriers such as calcium, aluminum, gold, or silver.

The one or more semiconductor layers 124 and 126 can be implemented with any organic electroluminescent material such as a light-emitting polymer, evaporated small molecule materials, light-emitting dendrimers or molecularly doped polymers.

Light incident from a high refractive index material onto an interface with a lower refractive index material or medium undergoes total internal reflection (TIR) for all incidence angles greater than the critical angle θ_{c}, defined by θ_{c} = sin 1 (n₂/n₁), where n₁ and n₂ are the refractive indices of the high refractive index material and low refractive index material, respectively. Due to the same reason, when the light emitted by the semiconductor layers 124 and 126 reaches their interface with the transparent substrate 118, a substantial amount of light is reflected back into the semiconductor layers 124 and 126.

Further, an electromagnetic field associated with this light reflected by TIR extends into the material with the lower refractive index in an evanescent standing wave, but the strength of this field diminishes exponentially with distance from the interface. Accordingly, absorbing or scattering entities located within this evanescent zone, typically about one wavelength thick, can disrupt the TIR and cause the light to pass through the interface. Therefore, presence of the internal light extraction layer 120 having textures to act as the absorbing and the scattering entities, eliminates or reduces the TIR, further thereby increasing the efficiency of the OLED. In a similar manner, the external light extraction layer 116 reduces or eliminates the TIR at an interface between the transparent substrate 118 and an ambient medium.

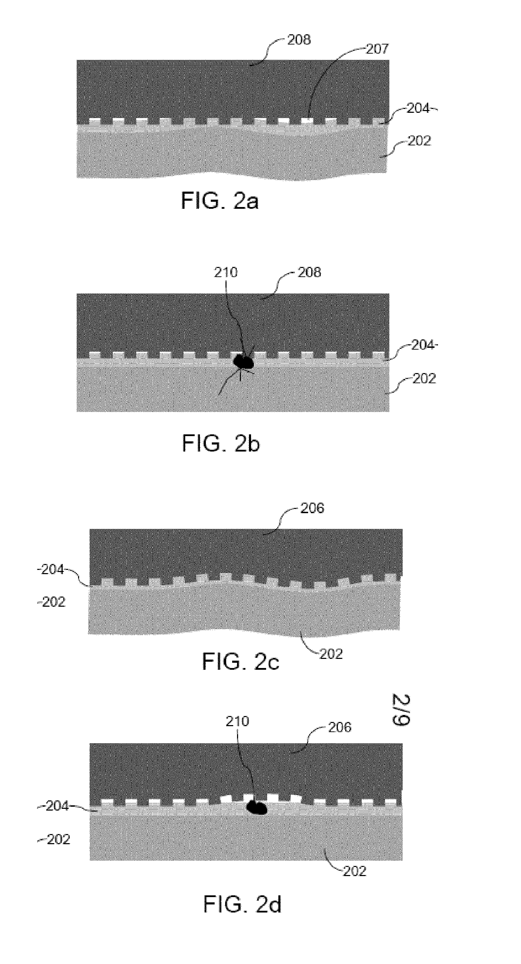

During the manufacturing of the photovoltaic device 100a and the OLED 100b, several methods are used to imprint the texture in the curable material. Most commonly used method for creating the texture in curable material is through photolithographic techniques. Main problem with photolithography is that it cannot be used for large area substrates and it is also very expensive, and therefore, is not feasible for mass production. In another method, a rigid stamp with a textured surface is pressed on curable material. The problem with use of the rigid stamp is that the rigid stamp is unable to take care of microscopic defects and macroscopic defects occur due to uneven surfaces of rigid substrates, impurities, foreign unwanted particles etc. The types of defects that can be created because of use of rigid stamps have been depicted in FIG. 2a and FIG. 2b. These defects significantly reduce light trapping or light extracting capabilities. Furthermore, particles trapped between the rigid stamp and rigid substrate can damage both stamp and substrate when the imprinting pressure is applied.

FIG. 2a depicts one type of defect that is created when the rigid stamp 208 is used to imprint texture on a layer of curable material 204 that has been wet coated on a substrate 202 that is uneven. In this case when the rigid stamp 208 is used to imprint the texture on the layer of curable material 204, voids 207 are created because the rigid stamp 208 is unable to conform to the uneven rigid substrate 202 and can leave voids or empty spaces 207. These types of defects can be termed as macroscopic defects. The size (length) of these defects can range from 100 micrometer up to 100 centimeter.

FIG. 2b depicts another type of defect that is created when the rigid stamp 208 is used to imprint texture in the layer of curable material 204 that has been wet coated on the rigid substrate 202 has impurities or any foreign unwanted particle or material 210. In this case, use of rigid stamp 208 to imprint the texture in the layer of curable material 204 can cause voids and/or internal cracks and can also damage the rigid stamp 208 and/or the rigid substrate 202. These types of defects can be termed as microscopic defects. The size (length) of these defects can range from 0.5 micrometer up to 10 millimeters.

In order to avoid defects that can be caused because of use of rigid stamp 208, the flexible stamp 206 is used to imprint the texture. The flexible stamp 206 is able to take care of both microscopic defects and macroscopic defects. The flexibility of the flexible stamp 206 ensures conformal contact with the rigid substrate 202. Due to this conformal behavior, the flexible stamp 206 is not sensitive to unevenness in the rigid substrate 202 or the hard defects/contamination in the layer of curable material 204 or the rigid substrate 202. In an example, as depicted in FIG. 2c, the flexible stamp 206 conforms to the unevenness of the rigid substrate 202, thus preventing creation of gaps on the layer of curable material 204. In another example, as depicted in FIG. 2d, the flexible stamp 206 prevents damage that could have been caused to the flexible stamp 206 and/or the rigid substrate 202 (refer FIG. 2b) because of presence of impurities or any foreign unwanted particle or material 210.

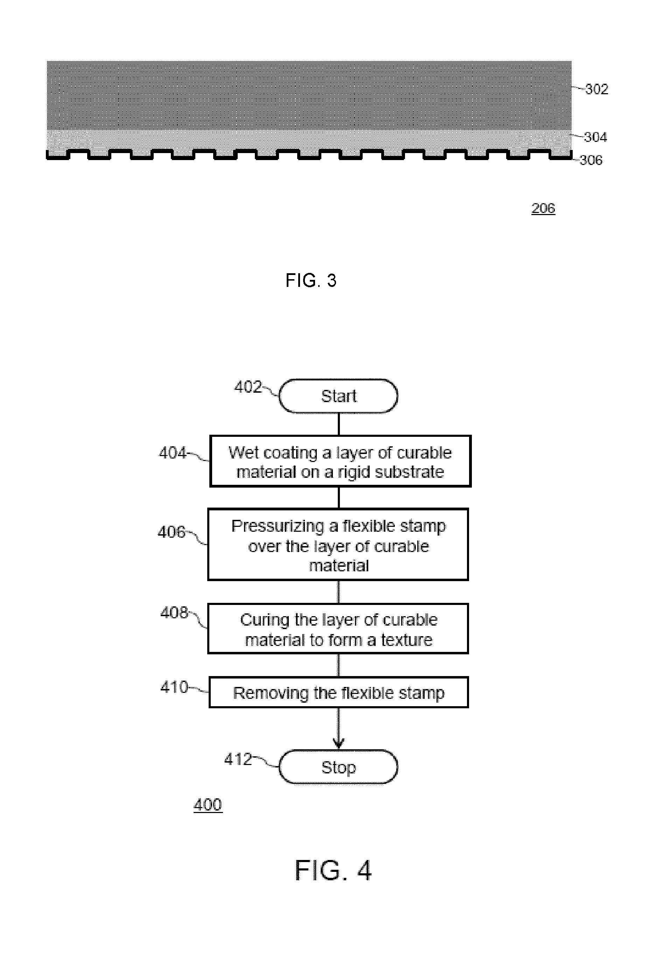

The flexible stamp 206 as shown in FIG. 3 is described in combination with FIG. 2. The flexible stamp 206 contains a top zone 302, a bottom zone 304 having a texture profile corresponding to the texture to be imprinted in the layer of curable material 204, and a release layer 306 disposed over the texture profile at the bottom zone 304. In some embodiments of the invention the flexible stamp 206 may not include the release layer 306, without impacting the scope of the invention. In one embodiment, the top zone 302 is made from a polymer such as polycarbonate, polyethylene terephthalate, polyethylenenaftalate or a combination of these materials and has a thickness between 50 - 500 µm. In another embodiment, the top zone 302 is made from a thin glass sheet having thickness less than 100 µm. The top zone 302 enables tolerance for macroscopic defects while imprinting of the texture on the layer of curable material 204. The top zone 302 has Young's Modulus between 0.1 Giga Pascal (GPa) and 10 GPa. This range of Young's Modulus is found to provide the desired stiffness to the top zone 302 that is required for operation of the flexible stamp 206. In case the Young's Modulus of the top zone 302 is less than 0.1 GPa, the handling of the flexible stamp 206 becomes problematic, especially for the flexible stamps of large area. If the Young's Modulus of the top zone is greater than 10 GPa, the flexible stamp 206 will be unable to conform to the macroscopic unevenness of the rigid substrate 202. Choice of Young's Modulus would also depend on choice of curable material and level of unevenness of substrate.

The bottom zone 304 can be made of cured acrylate polymer or cured polydimethylsiloxane and has a thickness between 1 - 100 µm. The bottom zone 304 enables tolerance for microscopic defects while imprinting of the texture on the layer of curable material 204. The bottom zone 304 has Young's Modulus between 0.5 Mega Pascal (MPa) and 3000 MPa and enables tolerance for microscopic defects during imprinting of the texture on the layer of curable material 204. In case the Young's Modulus of the bottom zone 304 is less than 0.5 MPa, the features of the texture have tendency to stick to each other. This tendency of the features of the texture is known is as "collapsing" of features. If the Young's Modulus of the bottom zone 304 is greater than 3000 MPa, the flexible stamp 206 will be unable to conform to the microscopic defects.

The release layer 306 can be made of a monolayer of octadecyl phosphonic acid or 1H, 1H, 2H, 2H-perfluorooctyl trichlorosilane and can have a thickness equivalent to thickness of one molecule. The "head" of the molecule is designed to chemically bond to the bottom zone 304 of the stamp while the "tail" of the molecule is designed to have no tendency to chemically bond to the curable material. Hence a thickness of one molecule is sufficient to act as a release layer. The release layer 306 prevents adhesion of the flexible stamp 206 with the layer of curable material 204 during imprinting of the texture in the layer of curable material 206.

In general, the pressure applied by the flexible stamp 206 on the layer of curable material 204 to imprint the texture depends on the material of the flexible stamp 206, viscosity of the curable material, and aspect ratio of texture to be imprinted. In the preferred embodiment, the pressure applied by the flexible stamp 206 ranges between 0.1 N/m² - 1000N/m².

In a real life example, the top zone 302 can be made of polycarbonate having a thickness of 200 µm and having Young's Modulus of 2 GPa. Further, the bottom zone 304 can be made of an UV-curable acrylate having a thickness of 10 µm and having Young's Modulus of 1760 MPa. In this example, the release layer 306 can be made of octadecyl phosphonic acid and can have a thickness equivalent to thickness of one molecule.

FIG. 4 is a flow chart describing a method 400 of imprinting a texture on a rigid substrate, in accordance with an embodiment of the present invention.

The method 400 of imprinting texture on the rigid substrate is initiated at step 402. Examples of the rigid substrate include, but are not limited to, glass, and transparent plastics. In one example, the rigid substrate could be an optically transparent glass, plastic or polymer for a photovoltaic device 100a such as a thin-film solar cell. In another example, the rigid substrate could be optically transparent glass, plastic or polymer substrate for OLED 100b. The rigid substrate provides strength and acts as a base for deposition of various layers for manufacturing of the solar cell 100a or the OLED 100b.

At step 404, a layer of curable material is wet coated on the rigid substrate. The curable material can include, but is not limited to, an acrylate, silica, silica-titania based sol-gel materials, a ultra-violet (UV) curable material and a photo-polymer lacquer. The curable material is converted to a hard plastic-like polymer or a glass-like material when exposed to heat or UV. Because of this property of curable materials, the layer of curable material is able to retain any texture embossed in it when it is cured by using mediums such as thermal radiations, light,ultra violet radiations, and the like. The thickness of the layer of curable material is less than 50 µm.

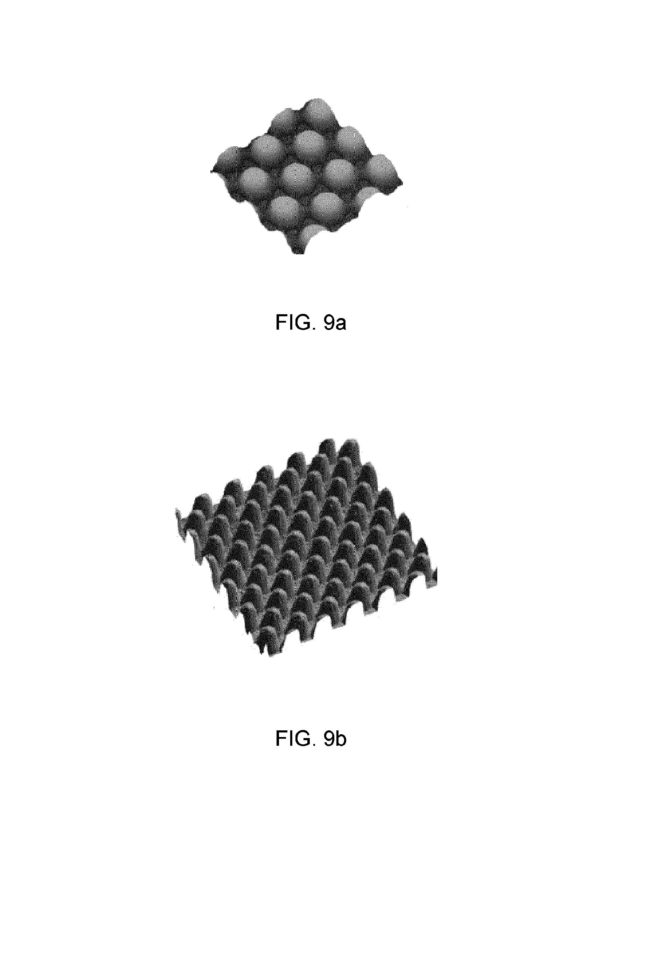

Following this, at step 406, the layer of curable material is pressurized using a flexible stamp to imprint the texture in the layer of curable material. The texture enhances the light-trapping capability in the photovoltaic device 100a. This texture may also help in scattering and/or diffraction of the light and thus, enhances the light path through the photovoltaic device and hence, enhances the chance of absorption of light by the semiconductor layers of the photovoltaic device. In case of the OLED 100b, the texture enhances the light-extraction capability of the OLED 100b. The textures can be of various shapes such as V-shaped or U-shaped features, a 1D or 2D periodic grating (rectangular or sinusoidal), a blazed grating, and random pyramids. Some exemplary textures have been depicted in FIG. 9a and FIG. 9b. Textures having light extraction abilities and/or textures having light trapping abilities are generically referred to as light management textures.

The flexible stamp contains a top zone, a bottom zone having a texture profile corresponding to the texture to be imprinted in the layer of curable material, and a release layer disposed over the texture profile at the bottom zone. In one embodiment, the top zone is made from a polymer such as polycarbonate, polyethylene terephthalate, polyethylenenaftalate or a combination of these materials and has a thickness between 50 - 500 µm. In another embodiment, the top zone is made from a thin glass sheet having thickness less than 100 µm. The top zone enables tolerance for macroscopic defects while imprinting of the texture in the layer of curable material. The top zone has Young's Modulus between 0.1 Giga Pascal (GPa) and 10 GPa. This range of Young's Modulus is preferred because the top zone provides the desired stiffness required for operation of the flexible stamp. In case the Young's Modulus of the top zone is less than 0.1 GPa, the handling of the flexible stamp becomes problematic, especially for the flexible stamps of large area. If the Young's Modulus of the top zone is greater than 10 GPa, the flexible stamp will be unable to conform to the macroscopic unevenness of the rigid substrate.

The bottom zone is made from cured acrylate polymer or cured polydimethylsiloxane and has a thickness between 1 - 100 µm. The bottom zone enables tolerance for microscopic defects while imprinting of the texture in the layer of curable material. The bottom zone has Young's Modulus between 0.5 Mega Pascal (MPa) and 3000 MPa and enables tolerance for microscopic defects during imprinting of the texture on the layer of curable material. In case the Young's Modulus of the bottom zone is less than 0.5 MPa, the features of the texture have tendency to stick to each other or deform during the imprinting process. The tendency of the features of the texture to stick to each other is known is as "collapsing" of features. If the Young's Modulus of the bottom zone is greater than 3000 MPa, the flexible stamp will be unable to conform to the microscopic defects.

The release layer is made from monolayer of octadecyl phosphonic acid or 1H, 1H, 2H, 2H-perfluorooctyl trichlorosilane and has a thickness equivalent to thickness of one molecule. The release layer prevents adhesion of the flexible stamp with the layer of curable material during imprinting of the texture in the layer of curable material.

In general, the pressure applied by the flexible stamp on the layer of curable material to imprint the texture depends on the material of the flexible stamp, viscosity of the curable material, and aspect ratio of texture to be imprinted. In the preferred embodiment, the pressure applied by the flexible stamp ranges between 0.1 N/m² - 1000N/m².

Moving on to step 408, the layer of curable material in which the texture has been imprinted is cured using a ultra-violet curing process or a heat curing process at step 408. In ultra-violet curing process, ultra-violet radiations are applied to solidify the curable material and hence fix the texture in the layer of curable material. In a similar way, in thermal curing process, heat is applied to the layer of curable material in order to fix the texture in the layer of curable material. The flexible stamp remains in contact with the layer of curable material during the curing of the layer of curable material. Once the curing of the layer of curable material is complete, the flexible stamp is removed at step 410. In some embodiments, after the layer of curable material has been cured, annealing of the layer of curable material is also performed. The main purpose of annealing is to eliminate maximum amount of the fluids or solvents released by the curable material and/or the rigid substrate before other layers can be deposited. Thereafter, the method 400 terminates at step 412. In some embodiments, curable material is pre-cured by using light and/or heat prior to imprinting the layer of the curable material. Pre-curing of curable material is performed in order to minimize flowing of curable material during the imprinting process.

In general, the method 400 of imprinting the texture on the rigid substrate can be used in manufacturing of photovoltaic devices such as solar cells, thin-film solar cells or OLEDs. The method 400 of imprinting texture on the rigid substrate can also be used in the manufacturing of glass or articles made of glass/transparent plastics. It would be readily apparent to those skilled in the art that the method 400 can also be applied, without deviating from the scope of the invention, for manufacturing any other suitable device or system. Moreover, the invention is not limited to the order of in which the steps are listed in the method 400. In addition, the method 400 can contain a greater or fewer numbers of steps than those shown in FIG. 4.

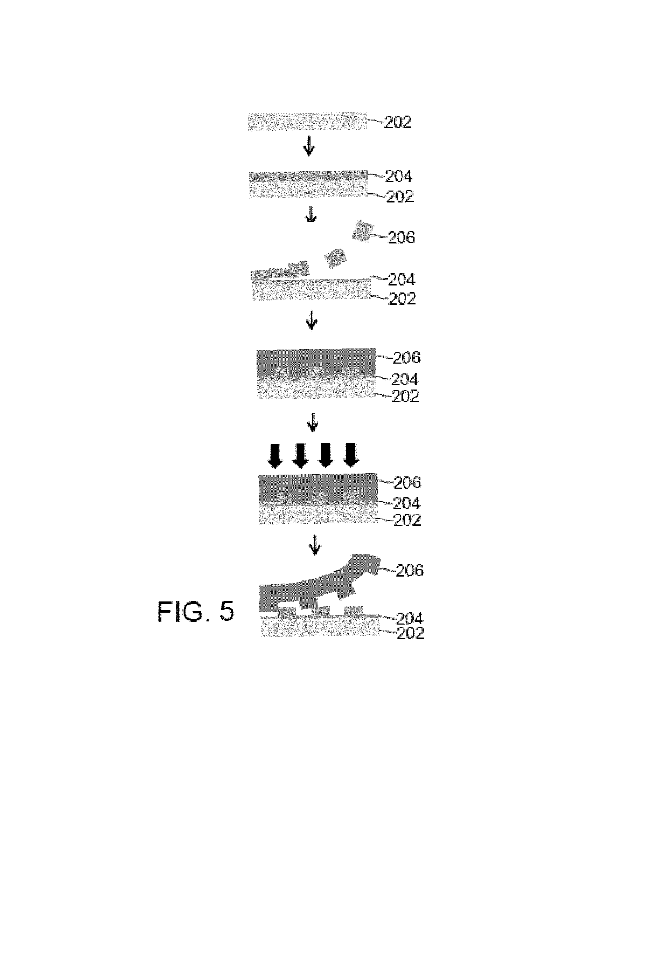

FIG. 5 is a diagrammatic illustration depicting exemplary method of imprinting texture on the rigid substrate 202, in accordance with some embodiments of the present invention. The rigid substrate 202 provides strength to the photovoltaic device 100a or the OLED 100b and is used as a starting point for deposition of other layers that constitute the photovoltaic device 100a or the OLED 100b.

Further, a layer of curable material 204 having thickness less than 50 µm is wet coated on the rigid substrate 202. For example, a 10 µm thick UV curable acrylate is deposited on a glass substrate using screenprinting or flexo printing.

Following this, the layer of curable material is pressurized using a flexible stamp 206 to imprint the texture in the layer of curable material 204. In continuation to above example, UV curable acrylate layer is pressurized at 10N/m2 using flexible stamp made of polycarbonate top zone and a release layer coated acrylate bottom zone. The texture enhances the light-trapping capability of semiconductor layers of the photovoltaic device 100a. In case of OLEDs, the texture enhances the light-extraction capability of the OLED 100b. The examples of the texture include, but are not limited to, V-shaped or U-shaped features, a 1D or 2D periodic grating (rectangular or sinusoidal), a blazed grating, and random pyramids.

Further, the layer of curable material 204 in which the texture has been imprinted is cured using a ultra-violet curing process or a thermal curing process. For above example, ultra-violet curing is used. The flexible stamp 206 remains in contact with the layer of curable material 204 during the curing of the layer of curable material 204. Once the curing of the layer of curable material 204 is complete, the flexible stamp 206 is removed.

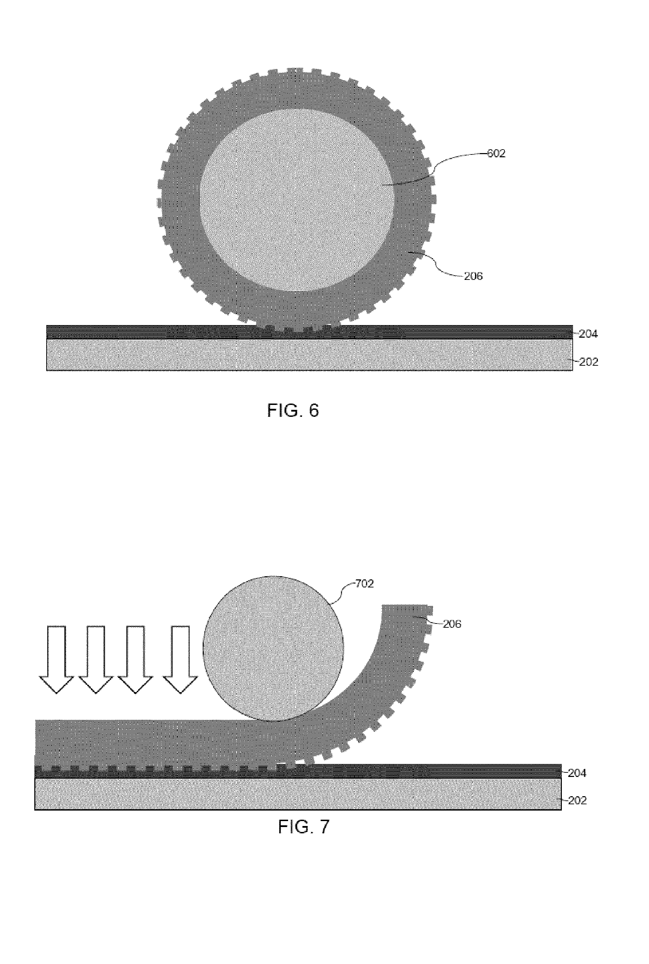

FIG. 6 is a diagrammatic illustration depicting use of the flexible stamp 206 to imprint a texture on the rigid substrate 202, in accordance with an embodiment of the present invention. The flexible stamp 206 is mounted on a roller 602. The roller 602 has a cylindrical shape and the flexible stamp 206 is mounted on the roller 602 in such a way that the flexible stamp 206 covers the entire curved surface area of the roller 602. Further, the roller 602 pressurizes the flexible stamp 206 on the layer of curable material 204 to imprint the texture in the layer of curable material 204. Above method is for illustration purpose only. It will be understood by a person ordinarily skilled in the art that there could be various known-in-the-art methods of pressurizing a flexible stamp on a layer of curable material.

FIG. 7 is another diagrammatic illustration depicting use of the flexible stamp 206 to imprint a texture on the rigid substrate 202, in accordance with another embodiment of the present invention. The flexible stamp 206 is in form of a sheet having similar dimensions and shape as that of the rigid substrate 202 and the layer of curable material 204. In this embodiment, the flexible stamp 206 is disposed over the layer of curable material 204 and pressure is applied using a roller 702. As the roller 702 moves over the flexible stamp 206 disposed over the layer of curable material 204, it provides adequate pressure to imprint the texture on the layer of curable material 204. Further, in both these embodiments depicted in FIG. 6 and FIG. 7, the pressure is only applied locally at the contact area of the roller. Above method is for illustration purpose only. It will be understood by a person ordinarily skilled in the art that there could be various known-in-the-art methods of pressurizing a flexible stamp on a layer of curable material.

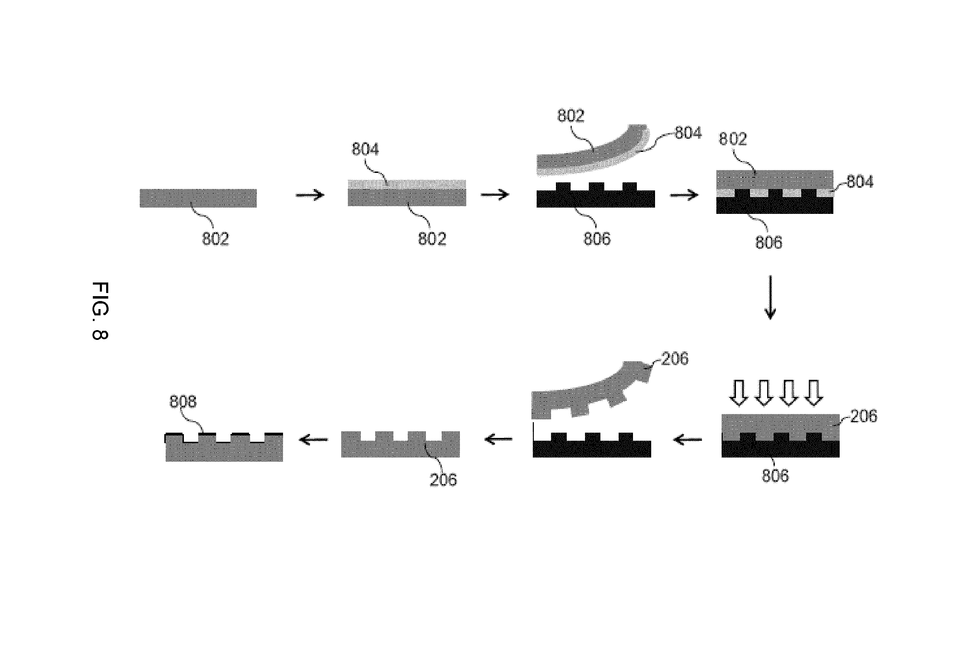

Moving on to FIG. 8, FIG. 8 is a diagrammatic illustration depicting exemplary method of manufacturing the flexible stamp 206, in accordance with an embodiment of the present invention. To describe FIG. 8, reference will be made to FIG. 3, although it is understood that the method of manufacturing the flexible stamp 206 can be implemented to manufacture any other suitable device. Moreover, the invention is not limited to the order of in which the steps are depicted in FIG. 8. In addition, the method of manufacturing the flexible stamp 206 can contain a greater or fewer numbers of steps than those shown in FIG. 8.

As already described in reference with FIG. 3, the flexible stamp 206 contains the top zone 302, the bottom zone 304 having a texture profile corresponding to the texture to be imprinted on the layer of curable material 204, and the release layer 306 disposed over the texture profile at the bottom zone 304. Firstly, a first layer 802 of polymer such as polycarbonate, polyethylene terephthalate, polyethylenenaftalate or a combination of these materials having a thickness between 50 - 500 µm is used to form the top zone 302. In another embodiment, the top zone 302 can also be made from a thin glass sheet having thickness less than 100 µm. Following this, a second layer 804 of curable acrylate polymer or curable polydimethylsiloxane having a thickness between 1 - 100 µm is wet coated over the first layer 802 to form the bottom zone 304. Following this, a mould 806 is used to imprint a texture in the second layer 804. The mould 806 has exactly the inverted texture that is to be imprinted on the layer of curable material 204. In one embodiment, the texture can be imprinted by rolling out the first layer 802 that has been wet coated by the second layer 804 over the mould 806 in such a manner that the second layer 804 faces the mould 806. Thereafter, curing of the second layer 804 is done using ultra-violet irradiation or heat. Curing of the second layer 804 ensures that bottom zone of the flexible stamp 206 achieves the required hardness. In a real life example, the UV curing of the second layer 804 is done at 0.012W/cm2 (in the UV-A wavelength range). Following this, the flexible stamp 206, thus formed, is removed from the mould 806 by rolling up the flexible stamp 206 from the mould 806. Thereafter, an anti-stick coating 808 is applied to the face of the flexible stamp 206 having the texture to form the release layer 306. The anti-stick coating 808 can be applied from a solution or through evaporation. The release layer 306, thus formed, prevents adhesion of the flexible stamp 206 with the layer of curable material 204 during imprinting of the texture in the layer of curable material 204. In cases where the curable material does not have the tendency to adhere to the bottom zone of the stamp a release layer is not required.

Various embodiments, as described above, provide a method of imprinting a texture on a rigid substrate using a flexible stamp, which has several advantages. One of the several advantages of some embodiments of this method is that it eliminates the defects that can be caused because of use of rigid stamps to imprint texture on rigid substrates. Another advantage of this invention is that it improves the efficiency and quality of photovoltaic devices and OLEDs because the microscopic and macroscopic defects created because of usage of rigid stamp are eliminated. Furthermore, the disclosed invention provides more tolerance to defects as compared to rigid stamps. Also, in using the current invention very thin layer of curable material can be used. While the invention has been disclosed in connection with the preferred embodiments shown and described in detail, various modifications and improvements thereon will become readily apparent to those skilled in the art. Accordingly, the present invention is not to be limited by the foregoing examples, but is to be understood in the broadest sense of the claims.

All documents referenced herein are hereby incorporated by reference.

## Claims

1. A method of imprinting a texture on a rigid substrate (202) wherein area of said rigid substrate (202) is greater than 50 square centimeters, further wherein said texture facilitates light management through said rigid substrate (202), said method comprising:
wet coating a layer of a curable material (204) on said rigid substrate (202);
pressurizing a stamp over said layer of said curable material (204) to imprint said texture;
curing said layer of curable material (204); and
removing said flexible stamp (206), **characterized in that** said stamp is a flexible stamp (206), wherein said flexible stamp (206)comprises a bottom zone (304) having a texture profile corresponding to said texture, said bottom zone (304) having Young's Modulus between 0.5 Mega Pascal (MPa) and 3000 MPa enabling tolerance for microscopic defects during imprinting of said texture, further wherein said flexible stamp (206) comprises a top zone (302) having Young's Modulus between 0.1 Giga Pascal (GPa) and 10 GPa enabling tolerance for macroscopic defects while imprinting of said texture.

2. The method of imprinting said texture on said rigid substrate (202) according to claim 1, wherein material of said top zone (302) is selected from the group comprising polycarbonate, polyethylene terephthalate and polyethylenenaftalate.

3. The method of imprinting said texture on said rigid substrate (202) according to claim 1 or 2, wherein material of said bottom zone (304) is selected from the group comprising acrylate polymer and cured polydimethylsiloxane.

4. The method of imprinting said texture on said rigid substrate (202) according to one of claims 1 to 3, further comprising adding a release layer (306) over said texture profile at said bottom zone (304), said release layer (306) preventing adhesion of said flexible stamp (206) with said curable material during imprinting of said texture on said layer of curable material (204).

5. The method of imprinting said texture on said rigid substrate (202) according to claim 4, wherein material of said release layer (306) is selected from the group comprising monolayer of octadecyl phosphonic acid and 1H, 1H, 2H, 2H-perfluorooctyl trichlorosilane.

6. The method of imprinting said texture on said rigid substrate (202) according to one of claims 1 to 5, wherein pressurizing said flexible stamp (206) over said layer of said curable material (204) comprises:
disposing said flexible stamp (206) over said layer of curable material (204); and
pressurizing said flexible stamp (206) using a roller (702) to imprint said texture on said layer of said curable material (204).

7. The method of imprinting said texture on said rigid substrate (202) according to one of claims 1 to 6, further comprising:
mounting said flexible stamp (206) on a roller; and
pressurizing said flexible stamp (206) using said roller (602) to imprint said texture on said layer of said curable material (204).

8. The method of imprinting said texture on said rigid substrate (202) according to one of claims 1 to 7, wherein said method is used in manufacturing of at least one of a thin-film solar cell and an Organic Light Emitting Device.

9. The method of imprinting said texture on said rigid substrate (202) according to one of claims 1 to 8, wherein thickness of said top zone (302) ranges between 50 to 500 µm and thickness of said bottom zone (304) ranges between 1 to 100 µm.

10. The method of imprinting said texture on said rigid substrate (202) according to one of claims 1 to 9, wherein thickness of said layer of curable material (204) is less than 50 µm.
